# EUROPEAN PATENT SPECIFICATION

(11) **EP 2 056 117 B1**
(45) Date of publication and mention of the grant of the patent: **07.07.2010**
(21) Application number: 07119668.7
(22) Date of filing: 30.10.2007
(51) Int. Cl.: G01R 31/12, G01R 31/26, G01R 31/28, G01R 31/02

(54) **A test station for testing leakage current through the insulating package of power electronic components, and a corresponding method**
Prüfstand zum Prüfen des Kriechstroms durch das Isoliergehäuse von leistungselektronischen Bauteilen und entsprechendes Verfahren
Station de test pour tester le courant de fuite dans l'emballage isolant des composants électroniques d'alimentation, et procédé correspondant

(43) Date of publication of application: 06.05.2009
(73) Proprietor: ISMECA Semiconductor Holding SA, 2300 La Chaux-de-Fonds (CH)
(72) Inventor: Charpié, Michel, 25500, Les Fins (FR); Cretenet, Davy, 25650, La Chaux-de-Gilley (FR)
(74) Representative: P&TS Patents & Technology Surveys SA

(56) References cited:
- EP-A- 0 147 921
- US-A- 4 806 857

## Description

### Field of the invention

The present invention concerns the testing of the insulation of power electronic components, such as triacs, thyristors, etc.

### Technical field

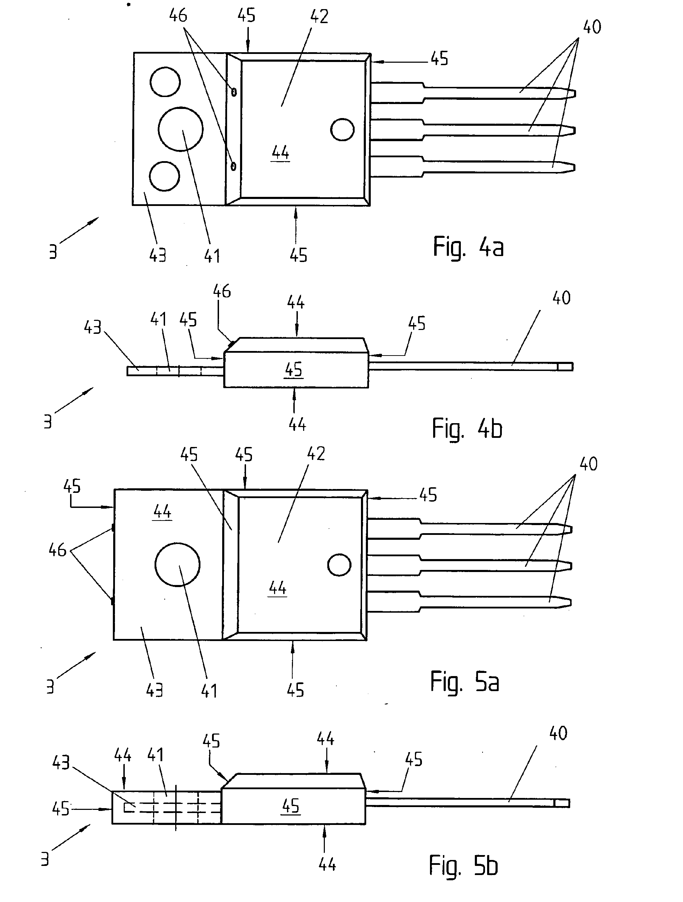

Figures 4a and 4b illustrate a known power electronic component 3. It comprises a certain number of pins 40 (in this case three), a package 42 of insulating material covering the semi-conductor circuit (not illustrated), and a radiator 43. A thru-hole 41 is often made in the radiator to allow it to be screwed onto the printed circuit or onto another element.

In the example of Figures 4a-4b, the metallic radiator 43 is of bare metal coming out of the insulating package 42. The insulating package 42 has two horizontal faces 44 and four upward directed faces 45, plus the side face of the thru hole 41. The upward and horizontal directions are defined when the component is assembled with the radiator horizontal, parallel to a horizontal printed circuit board. The figures further show two injection points 46 on the package that are visible in the form of irregularities in the molding left where the injection gates were placed, or at the junction of the molds.

Figures 5a and 5b illustrate another known power electronic component 3 comprising in this case a molded radiator 43, i.e. a radiator covered by the injected insulation. As in the embodiment of figures 4a and 4b, the radiator and the part of the insulating package covering this radiator are provided with a thru-hole 41. This component comprises 5 upward directed faces (plus the thru-hole 41) and three nearly horizontal faces. Other power electronic components have a different number of faces, of pins or a radiator covered only partially by the insulating package.

In this document, power electronic component will be understood as a component designed to receive a considerable voltage between its pins or between its pins and the insulating package, for example a voltage greater than 12 volts, typically a voltage of several tens or even several hundreds or thousands of volts. The insulation of the package is of paramount importance for this type of component, both for avoiding security problems in case of contact of persons or other components with the elements under voltage and for avoiding current leakages through the insulating material.

The need for miniaturized components requires that the thickness of the insulating material constituting the insulating package be reduced. The insulating thickness chosen at each point thus generally constitutes a compromise between, on the one hand, the necessity of ensuring the security and the correct functioning of the device, and, on the other hand, the wish to reduce the space requirement of the components as well as the cost of the raw materials of which they are constituted.

During manufacture and encasing of the power electronic components, it may sometimes happen that the electronic component and/or the radiator is not perfectly centered in the injection mold. In this case, the insulating thickness around the package is irregular and for example too high on one side and insufficient on the other side.

The insulation's resistance on the parts that are not sufficiently covered will then risk diminishing unacceptably whilst the capacitance increases. In certain extreme cases, portions of the component or of the radiator may even partly protrude out of the insulating package. Other problems can occur during encasing, notably irregularities caused by bubbles or impurities in the material.

One aim of the present invention is thus to propose a machine and a method for testing the insulation around power electronic components in order to detect and eliminate defective components.

US4924177 describes a device for testing triacs. The device aims to check that the circuit functions well electrically but does not supply any indication as to the quality of the insulation. A functional but poorly insulated triac will thus not be eliminated following the test. The device is suitable for testing individual triacs but is not adapted for testing in series multiple components on a testing line.

US5285151 describes an electric circuit for measuring the voltage of triacs or thyristor avalanches. Again, this circuit does not allow the insulation of the components to be tested.

EP147921 concerns a circuit for checking the breakdown resistance of semiconductor components. This circuit enables the voltage from which a component risks destruction by an electrostatic discharge on the insulating package to be measured. The results depend mainly on the characteristics of the encapsulated semiconductor circuit; the resistance and the capacitance of the insulating package have only a marginal influence on the results achieved. Furthermore, the voltages are applied at a single point on the insulating package, so that it is not possible with this circuit to detect whether other portions of the insulating package have sufficient thickness.

Another aim of the present invention is thus to check the quality of the insulation of the package around the power electronic components in order to detect possible faults at several critical points.

### Brief summary of the invention

According to the invention, those aims are reached among other with a test station for testing leakage current through the insulating package of power electronic components, said test station comprising:
first contact portions for applying a first test voltage on one or more pins of said tested components,
second contact portions for applying a second test voltage on several external faces of said insulating package of said tested components,
wherein said second contact portions are arranged for contacting several faces of said power electronic components, for example several mutually orthogonal or nearly orthogonal faces.

This machine thus allows a voltage to be applied between the pins and several points of the insulating package, notably critical points particularly exposed on vertical and horizontal faces.

It has indeed been observed that frequent insulation problems result from a poor positioning of the semiconductor component and/or of the radiator in their own horizontal plane. In this case, one of the edges of the component or of the radiator can sometimes find itself close to the insulation surface whose thickness can then prove in this place insufficient. It is thus of paramount importance that the quality of the insulation on the vertical faces of the insulating package, i.e. on the faces perpendicular to the plane of the radiator, be tested. The most critical points are constituted notably by the edges and lateral faces of the thru-hole 41, the injection points 46 and the portions of the insulating package between the pins.

In a preferred embodiment, the test station allows several components to be tested serially, and several components to be tested simultaneously.

### Brief Description of the Drawings

The invention will be better understood with the aid of the description of an embodiment given by way of example and illustrated by the figures, in which:
Fig. 1 is a diagrammatic top view of an apparatus comprising a plurality of test stations according to the invention.
Fig. 2A is a cross-section view from the side of a test station in open position.
Fig. 2B is a cross-section view from the front of a test station in open position.
Fig. 2C is a cross-section view from the side of a test station in closed position.

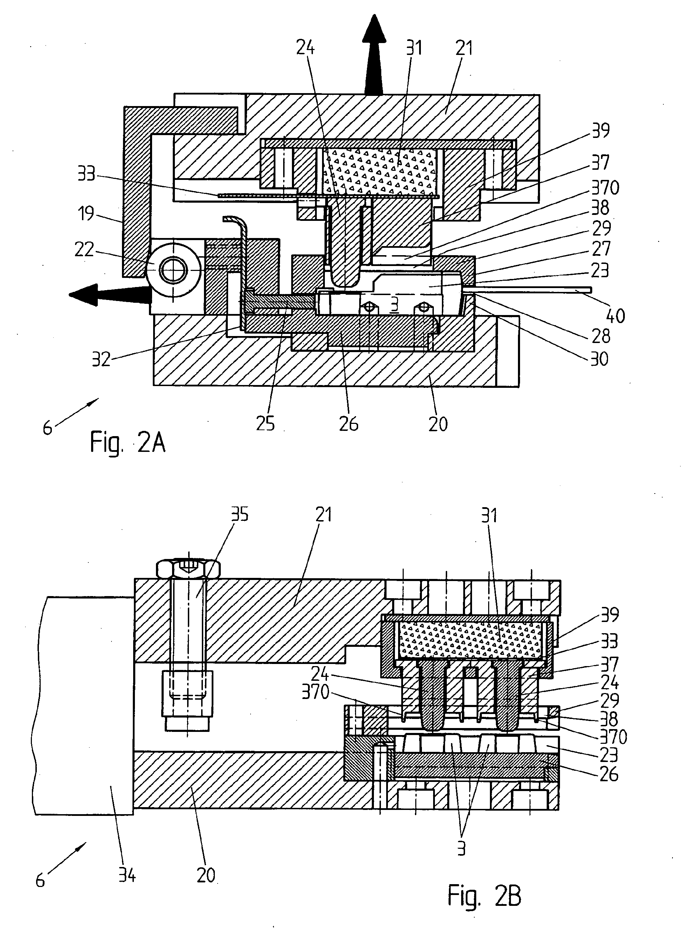

Fig. 2B is a cross-section view from the front of a test station in closed position.

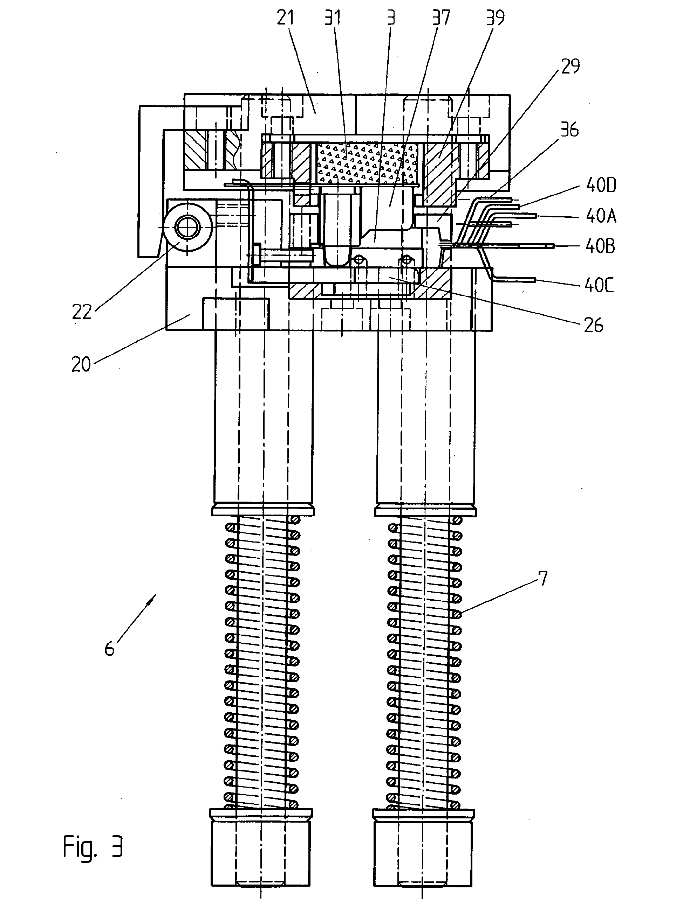

Fig. 3 is a cross-section view from the side of a test station in closed position, showing the electrical supply contactors.
Fig. 4a is a top view of a power electronic component comprising a bare radiating surface.
Fig. 4b is a side view of the power electronic component of Fig. 4a.
Fig. 5a is a top view of a power electronic component comprising a molded radiating surface.
Fig. 5b is a side view of the power electronic component of Fig. 5a.

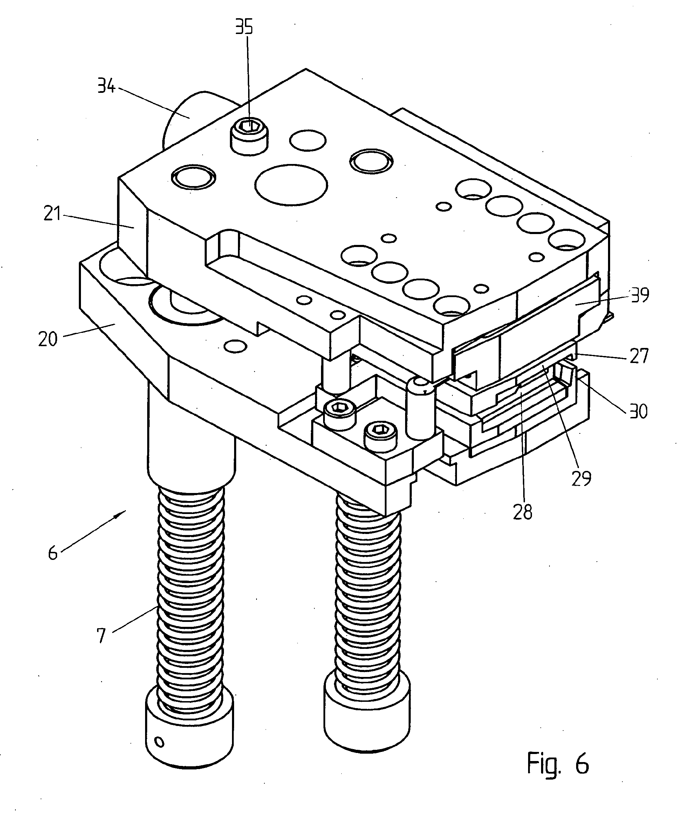

Fig. 6 is a perspective view of a test station according to an embodiment.

### Detailed Description of possible embodiments of the Invention

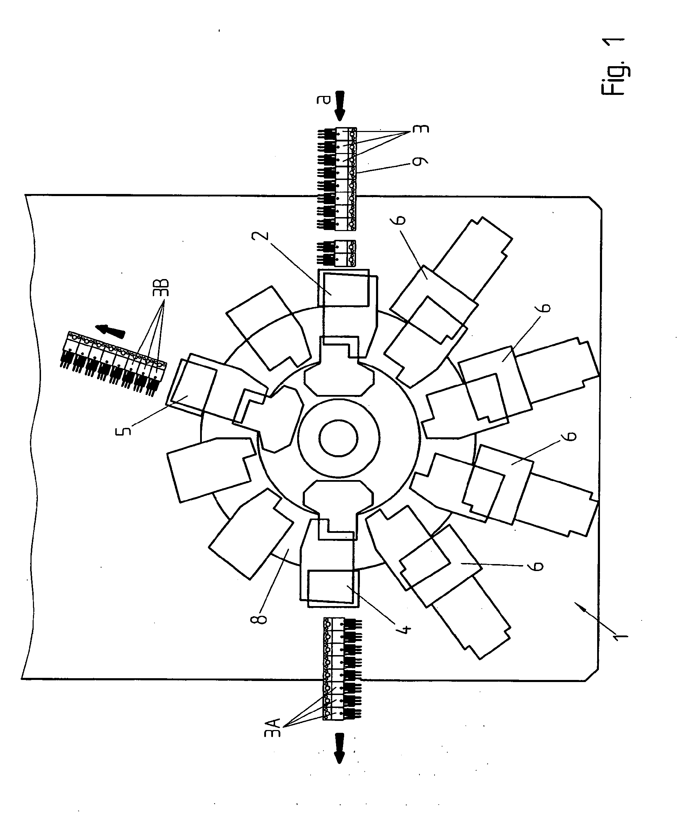

Figure 1 is a schematic top view of an apparatus comprising a plurality of working stations 2, 4, 5 and 6 around a rotating element 8, such as a rotating table or turret. The power electronic components 3 are delivered by a linear conveyor 9 to an input station 2 of the element 8. In an embodiment, the input station 2 simultaneously receives several components to test in parallel, for example two components.

The rotating element 8 is then indexed a number of times until all test stations 6 (four in the illustrated example) are filled with electronic components. The apparatus can thus test eight power components (two at each of the four test stations 6) simultaneously.

Defect components 3B are rejected at the exit station 5 while components 3A within acceptable limits leave the turret for further test or handling at the exit station 4. A computing system controls the indexation of the rotating element 8 and the delivery of the tested components to one of the exits 4 or 5, depending on the result of the insulation tests performed at the four test stations 6. In another embodiment, defect components are rejected at a later stage, for example on a conveyor after the exit station 4.

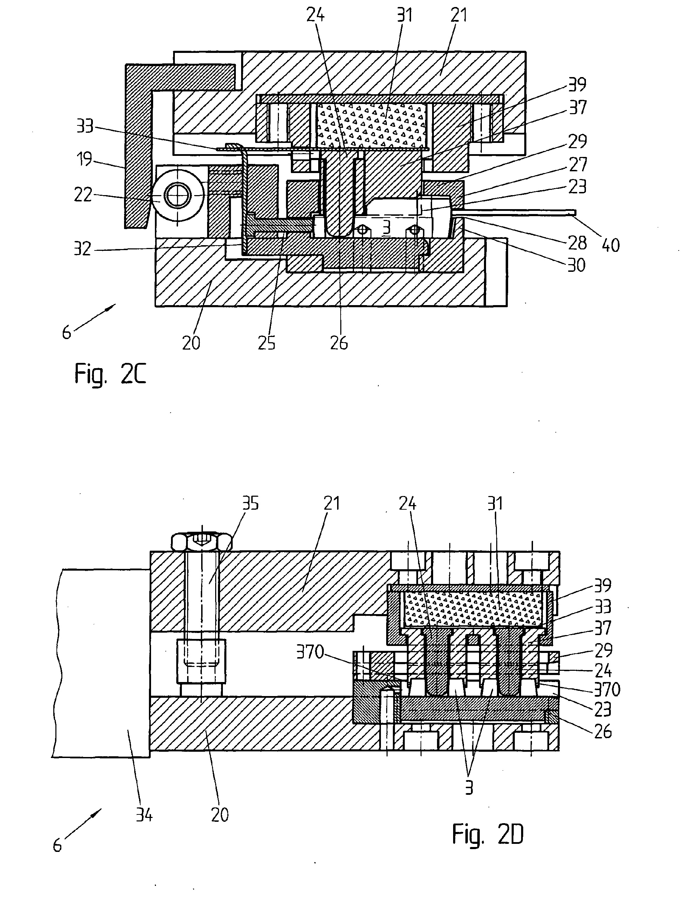

A possible embodiment of a test station 6 for power components is illustrated in Figures 2A to 2D. Each test station comprises a fixed base 20 and a vertically sliding cover 21 that can be moved by a motor or actuator (not shown). The cover 21 is open on Figures 2A and 2B and closed on Figures 2C, 2D.

The electronic components are inserted between the fixed base 20 and the open cover at the input station 2. In an embodiment, the components are moved in the direction of arrow a on Figure 1, i.e. in a direction perpendicular to the pages of the Figures 2A to 2D, using preferably pneumatic means. Their position in the test station along the axis a is determined by an abutment in the test station (not shown). As can be appreciated on Figures 2B and 2D, two or more components can be inserted side by side in a same test station, for simultaneous testing.

When the cover 21 is raised down by the motor, a thru-pin 24 is vertically displaced in the downward direction and engaged in a thru-hole 41 of each component 3 to be tested. This linear displacement allows for automatic centering of the components 3 in the test station. The pin 24 is moved through an opening 38 in the plate 29, until it establishes a contact with the lateral faces of the thru-hole 41. Simultaneously, contact portions 37 are moved downwardly through the opening 38 until they rest against the upper horizontal face 44 of the components 3.

A piece 19 unitary with the cover 21 displaces a cam 22 when the cover 21 is moved downward, so as to act on horizontal contact pins 25 and move them horizontally until they are pressed against vertical faces 45 of the components 3, preferably against the injection points 46.

An independent electric or pneumatic motor or actuator is used for opening the cover 21 at each of the stations 2, 4 and 5. The cover 21 is held closed in all other stations by springs 7 (Figure 3). In another embodiment, different actuators are used for displacing the different pins 24, 25 and contact portions 37 in the vertical or horizontal direction.

An accommodation 23 for the tested components 3 is provided between the parts 26, 27 and 30 of the test stations. In the illustrated example, two simultaneously tested components may be housed in the accommodation 23 of each test station, as can be realized with Figure 2B for example. Other numbers of components simultaneously tested in each test station could be imagined.

An electrically conductive plate 26, unitary with the base 20, defines with the insulating lower jaw 30 the lower face of this accommodation. Electric contact between the lower face of the component's insulating package will be established through this plate 26. Likewise, an upper plate 29, unitary with the fixed base 20, defines the upper face of the accommodation 23 and may come into contact with the upper face of the component to be tested, although the electrical contact with this face will be established primarily through the movable contacting portion 37.

The contacting portion 37 may be flat so as to contact the upper face of the components only. In the illustrated embodiment, this part 37 is n-shaped, as illustrated notably on Figures 2B and 2D, and comprise vertical legs 370 for contacting the lateral faces 45 of the component. As those faces 45 are not strictly vertical and may further comprise demolding rests and defects, the legs 370 are preferably less high than the faces 45, so as to contact only the upper part of those faces and avoid any jamming. A m-shaped part 37, comprising one or more intermediary legs resting against the internal lateral faces, is also possible. The legs 370 ensure a better electrical contact with the (almost) vertical lateral faces of the tested component, and offer a shielding for reducing the risk of electric arcs between those faces and portions of the device at a different voltage.

The thru-pins 24 allow establishment of an electrical contact with the side wall of a thru-hole 41 through each component to be tested. The diameter of the pin 24 thus corresponds precisely to the diameter of this thru-hole; the pin may be exchanged if other diameters are requested. This contact is especially useful for testing misalignment of the radiator in the insulating package, which may result in an insufficient width of the isolating material at the periphery of the thru-hole and thus in leakage currents.

The horizontal moving pins 25 allow establishment of a contact with vertical faces of the tested component 3, especially against the injection points of the insulating package on the face opposed to the pins 40. The injection points are small defects left on the surface of the insulation package at the gates of the injection mould during the injection moulding process; current leakage through those points are likely. One or several horizontal moving pins may be provided for testing various points, especially injection points, on the vertical surfaces of the component 3. A contact with the vertical faces of the component may also be provided through vertical plates or vertical portions of the plates 26 or 37.

A slot 28 is defined between the jaw 27 of the upper plate 29 and the corresponding lower jaw 30; the height and width of the slot is sufficient for the pins of the component to be tested. Figure 3 shows a view of a test station in which a component has been introduced. The insulating package of the component is entirely housed in the accommodation 23 whereas the pins extend mostly outside this accommodation through the slot 28.

A low resistivity, low capacity electric contact between the lower plate 26, the contact portion 37, the pins 24, 25, the upper plate 29 and the corresponding portions of the component's insulating package is of paramount importance. The vertical position of the pin 24 and of the contact portion 37 may be controlled by acting on the control signal applied to the actuator; an adjustable abutment 35 defines the lowest possible position.

Elastic means 31 are provided between the cover 21 and the contact portions 37, 24. In a preferred embodiment, the elastic means are made up of an elastomere which is slightly compressed when the cover 21 is in lower position. This ensures a sufficient pressure between the contact portion and the external faces of the component, even if the different parts are misaligned or if the machining precisions are imperfect.

Figure 3 is a side cut-view of the test station in closed position with an electronic component in the accommodation 23 between the base 20 and the cover 21. Power plugs are connected to a power supply (not shown) for electrically connecting the pins 40 of the component with a high voltage and the insulating package with the ground voltage. Highly noticeable on the figures are the springs 7 for pulling the cover 21 downward and maintaining it closed when no upward force is exerted by the opening motor or actuator.

The figure also shows how components with various types of pins (40A, 40B, 40C or 40D) may be inserted within a same power station; the connection is in any case made with the unbended part of the pin, close to the package.

Defects of the insulation package are detected by applying a strong DC and/or AC electric voltage using a power supply, for example more than 200 V, preferably up to 6KV, between the pins 40 and various points of the insulation package of the component to be tested.

The voltage is applied during a relatively long period, for example several seconds, and the leakage current that flows between the pins and the package is measured with an electronic circuit. The possibility to test simultaneously several components in each test station, and to have several test stations in parallel, increases the throughput of the overall test system.

### References

- 1: Base plate
- 2: Input station
- 3: Power component
- 3A: Positive tested power component
- 3B: Rejected power component
- 4: Exit station
- 5: Exit station for rejected components
- 6: Test stations
- 7: Springs
- 8: Rotating element (table or turret)
- 9: Conveyor
- 20: Basis
- 21: Cover
- 22: Cam
- 23: Accommodation for component to be tested
- 24: Thru-pin
- 25: Contact pin for a vertical face
- 26: Conductive base plate
- 27: Upper jaw
- 28: Slot
- 29: Upper plate
- 30: Lower jaw
- 31: Elastic element (elastomer)
- 32: Conductive plate
- 33: Conductive plate
- 34: Actuator for lowering or raising the cover
- 35: Adjustable abutment
- 36: Pin contactor
- 37: Contact portion for the upper surface
- 370: Vertical legs
- 38: Opening through the upper plate 29
- 39: Upper part
- 40: Power component pins
- 40A-D: Four possible positions of the pins
- 41: Thru-hole in power component
- 42: Power component insulating package
- 43: Radiator
- 44: Horizontal faces
- 45: Vertical faces
- 46: Injection points

## Claims

1. A test station (6) for testing leakage current through the insulating package (42) of power electronic components (3), said test station comprising:
first contact portions (36) for applying a first test voltage on one or more pins (40) of said tested components,
second contact portions (24, 37, 370, 25, 26) for applying a second test voltage on several external faces of said insulating package of said tested components,
**characterized in that** said second contact portions are arranged for contacting several mutually orthogonal faces of said power electronic components (3).

2. The test station of claim 1, said second contact portions being arranged for simultaneously contacting at least three different faces of said components (3).

3. The test station of claim 2, wherein said second portions are arranged for contacting a lower face, an upper face opposite said lower face, and a third face orthogonal to said upper and lower faces comprising at least one injection point (46) of said insulating package.

4. The test station of one of the claims 1 to 3, for testing power electronic components (3) comprising a molded radiator (43) with a thru-hole (41), wherein said second portions are arranged for contacting a lower face, an upper face opposite to said lower face, and the lateral sides of said thru-hole.

5. The test station of claim 4, said second portions comprising at least one pin (24) for insertion through said thru-hole (41) and for electric contacting said lateral faces.

6. The test station of one of the claims 1 to 5, comprising elastic means (31) for exerting a contact force between second portions (24, 37) and the corresponding faces of the tested component (3).

7. The test station of claim 6, said elastic means comprising an elastomere (31) for exerting a contact force on the lower or upper face of said component.

8. The test station of one of the claims 1 to 7, comprising pneumatic means for inserting the power electronic component (3) to test or for extracting the tested power electronic component from the test station.

9. The test station of one of the claims 1 to 8, which can be opened for inserting the power electronic component (3) to test or for extracting the tested power electronic component, or closed for establishing an electric contact with said pins (40) and with said insulating package (42).

10. The test station of one of the claims 1 to 9, said second portions comprising at least two parts (24+27; 25+27) linearly moveable one in relation to another for allowing the insertion and extraction of said component in an open position and the test in a closed position.

11. The test station of one of the claims 1 to 10, said second portions comprising at least one linearly moveable pin (24) for insertion in a hole (41) of said component.

12. The test station of one of the claims 1 to 11, said second portions comprising at least one linearly moveable portion (25) that can be moved in a direction parallel to the radiator of said power component for contacting at least one injection point of the said insulating package.

13. The test station of one of the claims 1 to 12, arranged for simultaneously contacting and testing at least two power electronic components.

14. The test station of one of the claims 1 to 13, comprising:
a basis (20);
a cover (21);
spring means (7) for pressing said cover against said basis, so as to close said test station;
a motor or actuator acting against said spring means for opening said test station during insertion of extraction of components (3),
at least some of said contact motions being moved with said cover or said basis when the test station is open or closed.

15. The test station of claim 14, further comprising second elastic means (31) between said cover and at least some of said contact portions.

16. The test station of one of the claims 1 to 15, further comprising a power supply for applying a voltage of at least 200 Volts between said pins (40) and said insulating package (42),
and an electronic test circuit for measuring the leakage current between said pin and said insulating package.

17. The test station of one of the claims 1 to 16, further comprising a conveyor for conveying power electronic components.

18. An arrangement comprising:
a plurality of test stations (2, 6, 4, 5) according to one of the claims 1 to 17,
conveying means arranged and controlled for simultaneously testing several power electronic components;
only a subset of said test stations (2, 4, 5) being provided with a motor or actuator for opening said test station.

19. A method for testing the insulation of power electronic components (3), with the following steps:
conveying the electronic component (3) to be tested to a test station (6),
establishing an electric contact between at least one first contactor (36) and at least one pin (40) of said electronic component and between at least one second contactor (24, 37, 370, 25, 26) and several points on orthogonal surfaces of the insulation of said electronic component;
establishing an electric voltage between said first contactor and said second contactor,
measuring an electric signal between said first contactor and said second contactor,
automatically evacuating the tested electronic component.

20. The method of claim 19, wherein several electronic components are tested simultaneously in several test stations.

21. The method of one of the claims 19 or 20, wherein several electronic components are tested simultaneously in each test station.

## Patentansprüche

1. Eine Teststation (6), um Kriechströme durch eine Isolierungsverpackung (42) von elektronischen Leistungskomponenten (3) zu testen, besagte Teststation umfassend:
erste Kontaktteile (36), um eine erste Testspannung auf einem oder mehreren Pins (40) von besagten getesteten Komponenten anzuwenden,
zweite Kontaktteile (24, 37, 370, 25, 26), um eine zweite Testspannung auf verschiedene externe Flächen von besagter Isolierungsverpackung der besagten getesteten Komponenten anzuwenden,
charakterisiert **dadurch**, dass besagte zweite Kontaktteile angeordnet sind, um in Kontakt mit verschiedenen gegenseitig orthogonalen Flächen von besagten elektronischen Leistungskomponenten (3) gebracht zu werden.

2. Die Teststation gemäss Anspruch 1, besagte zweite Kontaktteile sind angeordnet, um gleichzeitig mindestens drei verschiedenen Flächen von besagten Komponenten (3) zu kontaktieren.

3. Die Teststation gemäss Anspruch 2, wobei besagte zweite Teile angeordnet sind, um in Kontakt mit einer unteren Fläche, einer oberen Fläche, der der unteren Fläche gegenüber gelegen ist, und einer dritten Fläche, die zu besagten unteren Fläche und besagter oberen Fläche orthogonal angeordnet ist, zu treten, umfassend mindestens einen Einspritzpunkt (46) von besagter Isolierungsverpackung.

4. Die Teststation gemäss einem der Ansprüche 1 bis 3, um elektronische Leistungskomponenten (3) zu testen, umfassend ein Spritzgiessraditator (43) mit einem Durchgangsloch (41), wobei besagtes zweite Teile angeordnet sind, um eine untere Fläche, eine obere Fläche, die der unteren Fläche gegenüber gelegen ist, und Seitenflächen von besagten Durchgangsloch zu kontaktieren.

5. Die Teststation gemäss Anspruch 4, wobei besagte zweite Teile mindestens einen Pin (24) umfassen, um durch besagten Durchgangsloch (41) eingeführt zu werden, und einen elektrischen Kontakt zu besagten Seiten aufzubauen.

6. Die Teststation gemäss einem der Ansprüche 1 bis 5, umfassend elastische Mittel (31), um eine Kontaktkraft zwischen zweiten Teilen (24, 37) und den korrespondieren Flächen der getesteten Komponente (3) auszuüben.

7. Die Teststation gemäss Anspruch 6, wobei besagte elastische Mittel ein Elastomer (31) umfassen, um eine Kontaktkraft auf die untere oder obere Fläche der besagten Komponente auszuüben.

8. Die Teststation gemäss einem der Ansprüche 1 bis 7, umfassend pneumatische Mittel, um die elektronische Leistungskomponenten (3) zum Test einzuführen, oder um die elektronischen Leistungskomponenten aus der Teststation zu entnehmen.

9. Die Teststation gemäss einem der Ansprüche 1 bis 8, wobei welche geöffnet werden kann, um die elektronische Leistungskomponente (3) zur Test einzuführen, oder um die getestete elektronischen Leistungskomponente zu entnehmen, oder welche geschlossen werden kann, um einen elektronischen Kontakt mit besagten Pins (40) und besagter Isolierungsverpackung (42) herzustellen.

10. Die Teststation gemäss einem der Ansprüche 1 bis 9, wobei besagte zweite Teile mindestens zwei Teile (24+27, 25+27) umfassen, die linear beweglich in Beziehung zueinander sind, um die Einführung oder die Entnahme von besagter Komponente in einer offenen Position und den Test in geschlossner Position zu erlauben.

11. Die Teststation gemäss einem der Ansprüche 1 bis 10, wobei besagte zweite Teile mindestens einen linear beweglichen Pin (24) zur Einführung in einem Loch (41) von besagter Komponente.

12. Die Teststation gemäss einem der Ansprüche 1 bis 11, wobei besagte zweite Teile mindestens ein linear bewegliches Teil (25) umfassen, welche in eine Richtung parallel zu dem Radiator der Leistungskomponente bewegt wird, um mindestens mit einem Injektionspunkt von besagter Isolationsverpackung einen Kontakt aufzubauen.

13. Die Teststation gemäss einem der Ansprüche 1 bis 12, die angeordnet ist, um gleichzeitig zu mindestens zwei elektronische Leistungskomponenten einen Kontakt aufzubauen und diese zu testen.

14. Die Teststation gemäss einem der Ansprüche 1 bis 13, umfassend
eine Basis (20);
eine Abdeckung (21);
Federmittel (7), um besagte Abdeckung gegen besagte Basis zu drücken, um so besagte Teststationen zu schliessen,
ein Motor oder Stellglied, das gegen besagte Federmittel arbeitet, um besagte Teststation während der Einführung oder der Entnahme von Komponenten (3) zu öffnen, wobei
mindestens einige von besagten Kontaktbewegungen mit besagter Abdeckung oder besagter Basis bewegt werden, wenn die Teststation geöffnet oder geschlossen ist.

15. Die Teststation gemäss Anspruch 14, weiter umfassend zweite elastische Mittel (31) zwischen besagter Abdeckung und mindestens einem der besagten Kontaktteile.

16. Die Teststation gemäss einem der Ansprüche 1 bis 15, weiter umfassend eine Stromversorgung, um eine Spannung von mindestens 200 Volt zwischen besagten Pins (40) und besagter Isolierungsverpackung (42) anzulegen,
und einen elektronischen Testschaltkreis, um den Kriechstrom zwischen besagtem Pin und besagter Isolationsverpackung zu messen.

17. Die Teststation gemäss einem der Ansprüche 1 bis 16, weiter umfassend Transportmittel, um elektronische Komponenten zu transportieren.

18. Eine Anordnung umfassend
eine Vielzahl von Teststationen (2, 6, 4, 5) gemäss einem der Ansprüche 1 bis 17,
Transportmittel, die angeordnet sind und kontrolliert werden, um gleichzeitig mehrere elektronische Leistungskomponenten zu testen, wobei
nur eine Untergruppe von den besagten Teststationen (2, 4, 5) mit einem Motor oder Aktuator ausgestattet ist, um besagte Teststation zu öffnen.

19. Ein Verfahren, um die Isolierung von elektronischen Leistungskomponenten (3) zu testen, mit folgenden Verfahrensschritten:
Transportieren der elektronischen Komponente (3), die getestet werden soll, zu einer Teststation (6),
Herstellen eines elektronischen Kontakts zwischen mindestens einem ersten Kontaktelement (36) und mindestens einem Pin (40) von besagter elektronischer Komponente und zwischen mindestens einem zweiten Kontaktelement (24, 37, 370, 25, 26) und verschiedenen Punkten auf orthogonalen Oberflächen von der Isolierung von besagter elektronischer Komponente;
Herstellen einer elektrischen Spannung zwischen besagtem ersten Kontaktelement und besagtem zweiten Kontaktelement,
Messen eines elektrischen Signals zwischen besagtem ersten Kontaktelements und besagtem zweiten Kontaktelements,
automatisches Entfernen der getesteten elektronischen Komponente.

20. Das Verfahren gemäss Anspruch 19, wobei mehrere elektronische Komponenten gleichzeitig in mehreren Teststationen getestet werden.

21. Das Verfahren gemäss einem der Ansprüche 19 oder 20, wobei mehrere elektronische Komponenten gleichzeitig in jeder Teststation getestet werden.

## Revendications

1. Une station de test (6) pour tester le courant de fuite à travers l'enrobage isolant (42) de composants électroniques d'alimentation (3), ladite station de test comprenant:
des premières portions de contact (36) pour appliquer une première tension de test sur une ou plusieurs broches (40) desdits composants testés,
des secondes portions de contact (24, 37, 370, 25, 26) pour appliquer une seconde tension de test sur plusieurs faces externes dudit enrobage isolant desdits composants testés,
dans laquelle lesdites secondes portions de contact sont disposées pour contacter plusieurs faces orthogonales entre elles desdits composants électroniques d'alimentationt (3).

2. La station de test selon la revendication 1, dans laquelle lesdites secondes portions de contact sont disposées pour contacter simultanément au moins trois faces différentes desdits composants (3).

3. La station de test selon la revendication 2, dans laquelle lesdites secondes portions sont disposées pour contacter une face inférieure, une face supérieure opposée à ladite face inférieure, et une troisième face orthogonale auxdites faces supérieure et inférieure comprenant au moins un point d'injection (46) dudit enrobage isolant.

4. La station de test selon l'une des revendications 1 à 3, pour tester des composants électroniques d'alimentation (3) comprenant un radiateur moulé (43) avec un trou (41), dans laquelle lesdites secondes portions sont disposées pour contacter une face inférieure, une face supérieure opposée à ladite face inférieure, et les faces latérales dudit trou.

5. La station de test selon la revendication 4, dans laquelle lesdites secondes portions comprennent au moins une goupille (24) pour l'insérer dans ledit trou (41) et pour contacter lesdites faces latérales électriquement.

6. La station de test selon l'une des revendications 1 à 5, comprenant des éléments élastiques (31) pour exercer une force de contact entre les secondes portions (24, 37) et les faces correspondantes du composant testé (3).

7. La station de test selon la revendication 6, lesdits éléments élastiques comprenant un élastomère (31) pour exercer une force de contact sur la face inférieure ou supérieure dudit composant.

8. La station de test selon l'une des revendications 1 à 7, comprenant des moyens pneumatiques pour insérer le composant électronique d'alimentation (3) à tester ou pour extraire le composant électronique d'alimentation testé de la station de test.

9. La station de test selon l'une des revendications 1 à 8, pouvant être ouverte pour insérer le composant électronique d'alimentation (3) à tester ou pour extraire le composant électronique testé, ou fermée pour établir un contact électrique avec lesdites broches (40) et avec ledit enrobage isolant (42).

10. La station de test selon l'une des revendications 1 à 9, lesdites secondes portions comprennent au moins deux parts (24+27; 25+27) déplaçables l'une par rapport à l'autre de manière linéaire pour permettre l'insertion et l'extraction dudit composant dans une position ouverte et le test dans une position fermée.

11. La station de test selon l'une des revendications 1 à 10, lesdites secondes portions comprennent au moins une goupille déplaçable de manière linéaire (24) pour pouvoir être insérée dans un trou (41) dudit composant.

12. La station de test selon l'une des revendications 1 à 11, lesdites secondes portions comprennent au moins une portion déplaçable de manière linéaire (25) qui peut être déplacée dans une direction parallèle au radiateur dudit composant d'alimentation pour être mise en contact avec au moins un point d'injection dudit enrobage isolant.

13. La station de test selon l'une des revendications 1 à 12, configurée pour contacter et tester simultanément au moins deux composants d'alimentation.

14. La station de test selon l'une des revendications 1 à 13, comprenant:
une base (20);
un couvercle (21);
des ressorts (7) pour appuyer ledit couvercle sur ladite base, de manière à fermer ladite station de test;
un moteur ou servomoteur agissant contre lesdits ressorts pour ouvrir ladite station de test durant l'insertion ou l'extraction des composants (3),
au moins certaines portions desdites portions de contact étant déplacées avec ledit couvercle ou ladite base lorsque la station de test est ouverte ou fermée.

15. La station de test selon la revendication 14, comprenant de plus des seconds éléments élastiques (31) entre ledit couvercle et au moins certaines des portions de contact.

16. La station de test selon l'une des revendications 1 à 15, comprenant de plus une source électrique pour appliquer une tension d'au moins 200 Volts entre lesdites pattes (40) et ledit enrobage isolant (42),
et un circuit de test électronique pour mesurer le courant de fuite entre lesdites pattes et ledit enrobage isolant.

17. La station de test selon l'une des revendications 1 à 16, comprenant de plus une chaîne de transport pour transporter les composants électroniques d'alimentation.

18. Un dispositif comprenant:
plusieurs stations de test (2, 6, 4, 5) selon l'une des revendications 1 à 17,
des moyens de transport disposés et contrôlés pour tester simultanément plusieurs composants électroniques d'alimentation;
seulement un sous-ensemble desdites stations de test (2, 4, 5) comportant un moteur ou un servomoteur pour ouvrir ladite station de test.

19. Une méthode pour tester l'isolation de composants électroniques d'alimentation (3), selon les étapes suivantes:
transporter les composants électroniques (3) à tester jusqu'à une station de test (6),
établir un contact électrique entre au moins une première portion de contact (36) et au moins une patte (40) dudit composant électronique et au moins une seconde portion de contact (24, 37, 370, 25, 26) et plusieurs points sur les surfaces orthogonales de l'isolant dudit composant électronique;
établir une tension électrique entre ladite première et ladite seconde portion de contact,
mesurer un signal électrique entre ladite première et ladite seconde portion de contact,
évacuer automatiquement le composant électronique testé.

20. La méthode selon la revendication 19, dans laquelle plusieurs composants électroniques sont testés simultanément dans plusieurs stations de test.

21. La méthode selon l'une des revendications 19 à 20, dans laquelle plusieurs composants électroniques sont testés simultanément dans chaque station de test.
